# EUROPEAN PATENT SPECIFICATION

(11) **EP 4 105 747 B1**
(45) Date of publication and mention of the grant of the patent: **22.01.2025**
(21) Application number: 22174615.9
(22) Date of filing: 20.05.2022
(51) Int. Cl.: G05B 19/418

(54) **PREDICTION SYSTEM, PREDICTION METHOD, AND NON-TRANSITORY STORAGE MEDIUM**
VORHERSAGESYSTEM, VORHERSAGEVERFAHREN UND NICHTFLÜCHTIGES SPEICHERMEDIUM
SYSTÈME DE PRÉDICTION, PROCÉDÉ DE PRÉDICTION ET SUPPORT D'ENREGISTREMENT NON TRANSITOIRE

(30) Priority: 15.06.2021 JP 2021099239
(43) Date of publication of application: 21.12.2022
(73) Proprietor: TOYOTA JIDOSHA KABUSHIKI KAISHA, Toyota-shi, Aichi-ken, 471-8571 (JP)
(72) Inventor: HIROKAWA, Koh, Toyota-shi, Aichi-ken, 471-8571 (JP)
(74) Representative: Kuhnen & Wacker Patent- und Rechtsanwaltsbüro PartG mbB

(56) References cited:
- EP-A1- 3 316 061
- DE-A1- 102019 110 360
- DE-A1- 102020 210 967
- CHEN JOSEPH C ET AL: "Artificial neural network-based online defect detection system with in-mold temperature and pressure sensors for high precision injection molding", THE INTERNATIONAL JOURNAL OF ADVANCED MANUFACTURING TECHNOLOGY, SPRINGER, LONDON, vol. 110, no. 7-8, 1 September 2020 (2020-09-01), pages 2023 - 2033, XP037240571, ISSN: 0268-3768, [retrieved on 20200901], DOI: 10.1007/S00170-020-06011-4

## Description

### BACKGROUND OF THE INVENTION

### 1. Field of the Invention

The invention relates to a prediction system, a prediction method, and a non-transitory storage medium.

### 2. Description of Related Art

Generally, a technology for predicting a defect of a product is used in various industries including the automobile industry. There is a characteristic prediction apparatus described in WO 2018/062398 A1 as an example of such a technology. When parameters that indicate manufacturing conditions of an aluminum product are input, the characteristic prediction apparatus predicts the characteristics of the aluminum product by using a neural network that outputs the characteristic values of the aluminum product manufactured under the manufacturing conditions. EP 3 316 061 A1 further discloses a procedure for predicting the mechanical properties of parts obtained by casting.

### SUMMARY OF THE INVENTION

However, the characteristic prediction apparatus as described in WO 2018/062398 A1 predicts a defect of a product based on only the manufacturing conditions of a product, so the characteristic prediction apparatus is not capable of predicting a defect due to the shape of a product.

The above problem is solved by the invention as set forth in the independent claims which provide a prediction system, a prediction method, and a non-transitory storage medium that are capable of predicting a defect due to the shape of a product. Advantageous configurations of the invention are set forth in the sub-claims.

A first aspect of the invention relates to a prediction system as set forth in claim 1, the prediction system configured to predict a defect of a target product. The prediction system includes a first pre-trained model trained based on a defect characteristic value indicating a defect associated with a location in an existing product, a feature of a three-dimensional shape of the existing product, and conditional information indicating a manufacturing condition of the existing product. The first pre-trained model is configured to, when a feature of a three-dimensional shape of the target product is input, output a defect characteristic value indicating a defect associated with a location in the target product.

The prediction system further includes a second pre-trained model configured to, when shape information indicating the three-dimensional shape of the existing product is input, output the feature of the three-dimensional shape of the existing product, and the first pre-trained model is trained by using the feature output from the second pre-trained model.

When the product is a casting, the defect of the product, indicated by the defect characteristic value, may include at least one of seizure, shrinkage, flow line, galling, raw material deformation, die cracking, and entrapment of the product.

The defect characteristic value may include a value indicating a degree of the defect of the product.

When the product is a casting, the first pre-trained model may be further trained by at least one of a die volume of the casting, a casting volume, a casting surface area, and a thickness of the casting.

When the product is a casting, the manufacturing condition may include at least one of molten metal type, molten metal temperature, internal cooling temperature, water flow time, die temperature, die surface treatment, cycle time, die time, die opening sequence, spray application amount, spray time, and air blow sequence.

The prediction system may further include a display device, and the defect characteristic value indicating the defect associated with the location in the target product may be displayed on the display device.

A second aspect of the invention relates to a prediction method of predicting a defect of a target product as set forth in claim 7. The prediction method includes inputting, by a computer, a feature of a three-dimensional shape of the target product to a first pre-trained model, trained based on a defect characteristic value indicating a defect associated with a location in an existing product, shape information indicating a three-dimensional shape of the existing product, and conditional information indicating a manufacturing condition of the existing product, and causing the first pre-trained model to output a defect characteristic value indicating a defect associated with a location in the target product. The configurations applicable to the prediction system according to the first aspect may also be applied to the prediction method according to the second aspect.

The prediction method further includes inputting, by the computer, the shape information indicating the three-dimensional shape of the existing product to a second pre-trained model and causing the second pre-trained model to output a feature of the three-dimensional shape of the existing product; and causing, by the computer, the first pre-trained model to train by using the feature output from the second pre-trained model.

A third aspect of the invention relates to a non-transitory storage medium as set forth in claim 13, the non-transitory storage medium storing a program that is a first pre-trained model configured to predict a defect of a target product, and a program that is a second pre-trained model. The first pre-trained model is trained based on a defect characteristic value indicating a defect associated with a location in an existing product, a feature of a three-dimensional shape of the existing product, and conditional information indicating a manufacturing condition of the existing product, and the first pre-trained model is configured to, when a feature of a three-dimensional shape of the target product is input, output a defect characteristic value indicating a defect associated with a location in the target product. The second pre-trained model is configured to, when shape information indicating the three-dimensional shape of the existing product is input, output the feature of the three-dimensional shape of the existing product. The first pre-trained model is trained by using the feature output from the second pre-trained model.

According to the aspects of the invention, it is possible to provide a prediction system, a prediction method, and a non-transitory storage medium that are capable of predicting a defect due to the shape of a product.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 is a block diagram showing the configuration of a prediction apparatus according to an embodiment of the invention;
FIG. 2 is a flowchart showing an example of a process to be executed by the prediction apparatus according to the embodiment of the invention;
FIG. 3 is a flowchart showing another example of a process to be executed by the prediction apparatus according to the embodiment of the invention; and
FIG. 4 is a view showing an example of an image showing a prediction result according to the embodiment of the invention.

### DETAILED DESCRIPTION OF EMBODIMENTS

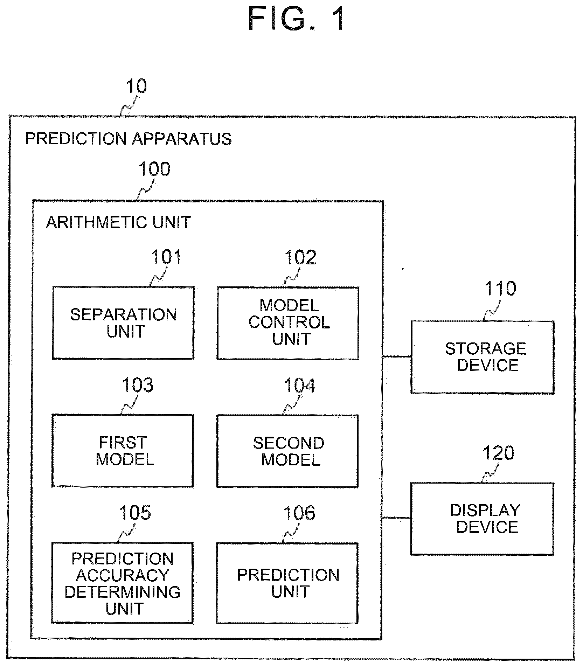

Hereinafter, an embodiment of the invention will be described with reference to the accompanying drawings. FIG. 1 is a block diagram showing the configuration of a prediction apparatus 10 according to the embodiment of the invention. The prediction apparatus 10 predicts a defect of a target product. Specific examples of the prediction apparatus 10 include information processing apparatuses, such as a server and a personal computer (PC); however, the prediction apparatus 10 is not limited thereto. The prediction apparatus 10 may be regarded as a prediction system. Examples of the target product include castings for use in vehicles, such as automobiles.

The prediction apparatus 10 includes an arithmetic unit 100, a storage device 110, and a display device 120. The arithmetic unit 100 is an arithmetic unit, such as a central processing unit (CPU) and a micro processing unit (MPU). The arithmetic unit 100 executes a prediction method of predicting a defect of a target product by reading and running a program saved in the storage device 110.

The storage device 110 is a storage device in which the program to be run by the arithmetic unit 100 and various data such as information on an existing product and information on the target product are saved. Specifically, the information on the existing product includes a defect characteristic value indicating a defect associated with a location in the existing product, shape information indicating the three-dimensional shape of the existing product, and conditional information indicating the manufacturing condition of the existing product. The defect characteristic value and shape information of the existing product are obtained by means of, for example, the computer-aided engineering (CAE) analysis of the existing product. The information on the target product includes shape information indicating the three-dimensional shape of the target product and conditional information indicating the manufacturing condition of the target product.

When the product is a casting, the defect of the product, indicated by the defect characteristic value, may be a general casting defect. Specific examples of the casting defect include seizure, shrinkage, flow line, galling, raw material deformation, die cracking, and entrapment. The raw material deformation means an undesirable deformation that can occur when a casting is cooled to an ordinary temperature after the casting is formed in a casting process. The defect of the product, indicated by the defect characteristic value, is not limited to these examples.

The defect characteristic value is a quantitative variable and is a value indicating the degree of a defect of the product. The defect characteristic value indicates the degree of a defect of the product by its magnitude.

When the product is a casting, the manufacturing condition indicated by the conditional information may be a condition that is set in a general casting process. Specific examples of the manufacturing condition indicated by the conditional information include molten metal type, molten metal temperature, internal cooling temperature, water flow time, die temperature, die surface treatment, cycle time, die time, die opening sequence, spray application amount, spray time, and air blow sequence in order to manufacture a casting. The manufacturing condition is not limited to these examples.

The molten metal type is a type of molten metal. The molten metal temperature is the temperature of molten metal. The internal cooling temperature is the temperature of water that passes through the inside of a die for cooling a casting. The die temperature is the temperature of a die at the time of forming a casting. The water flow time is a time taken by water to pass through the inside of the die. The die surface treatment is a heat treatment or the like that is carried out to reduce abrasion of a die surface.

The cycle time is a time required in a casting process at the time when castings are continuously produced. The cycle of the casting process consists of die closing, pouring, solidification, die opening, removal of a casting, mold release agent application, air blow, and die closing.

The die time is a time included in a cycle time and is a time from solidification, that is, completion of pouring, to die opening. The die opening sequence is the sequence of opening a die made up of a plurality of die components. The spray application amount is the amount of application of die release agent used to easily remove a casting from a die. The spray time is a time to apply die release agent. The air blow sequence is the sequence of removing die release agent remaining on a die with air blow.

The programs to be run by the arithmetic unit 100 include a separation unit 101, a model control unit 102, a first model 103, a second model 104, a prediction accuracy determining unit 105, and a prediction unit 106. In another embodiment, an integrated circuit, such as field-programmable gate array (FPGA) and application specific integrated circuit (ASIC), may run these programs. A server, a PC, an arithmetic unit, and an integrated circuit may be regarded as a computer.

The separation unit 101 is a program that acquires information on the existing product from the storage device 110 and that separates the information on the existing product into the defect characteristic value of the existing product and the shape information of the existing product.

The first model 103 is a program trained based on the defect characteristic value indicating a defect associated with a location in the existing product, a feature of the three-dimensional shape of the existing product, and the conditional information indicating the manufacturing condition of the existing product. The first model 103 may be trained by using machine learning, such as deep learning. In the case of, for example, deep learning, the first model 103 can be implemented by a neural network. Machine learning is not limited to deep learning, and another technology may be adopted.

The second model 104 is a program that, when the shape information indicating the three-dimensional shape of the existing product is input, outputs the feature of the three-dimensional shape of the existing product. The second model 104 may be implemented by a convolutional neural network. The feature of the three-dimensional shape can be expressed in the form of a feature vector.

The model control unit 102 is a program that controls the first model 103 and the second model 104. The model control unit 102 is capable of training the second model 104 by inputting the shape information indicating the three-dimensional shape of the existing product to the second model 104. The model control unit 102 is capable of training the first model 103 by using the feature output from the second pre-trained model 104, the defect characteristic value of the existing product, obtained by the separation unit 101, and one or more pieces of the conditional information on the existing product, saved in the storage device 110.

In another embodiment, the model control unit 102 may input not only the feature output from the second pre-trained model 104 but also another feature of the existing product to the first model 103. When the existing product is a casting, examples of the other feature include a die volume of the casting, a casting volume, a casting surface area, and a thickness of the casting. In other words, the first model 103 may be further trained by at least one of the die volume of the casting, the casting volume, the casting surface area, and the thickness of the casting.

The prediction accuracy determining unit 105 is a program that compares the defect characteristic value output from the first model 103 with the defect characteristic value of the existing product and that determines whether the defect prediction accuracy of the first model 103 is higher than or equal to a set accuracy. With this determination, the defect characteristic value at each location in the existing product, obtained by simulation, such as CAE analysis, can be used as the defect characteristic value of the existing product.

A defect characteristic value is able to indicate the degree of defect of a product. The prediction accuracy determining unit 105 is able to, when the difference between the defect characteristic value output from the first model 103 and the defect characteristic value of the existing product, obtained by simulation, is less than or equal to a prescribed value, determine that the defect prediction accuracy of the first model 103 is higher than or equal to the set accuracy.

The prediction unit 106 is a program that predicts a defect of the target product by using the first pre-trained model 103. Specifically, the prediction unit 106 is capable of predicting a defect of the target product by inputting, to the first pre-trained model 103, a feature indicating a feature quantity of the three-dimensional shape of the target product. The prediction unit 106 displays a defect characteristic value indicating a defect associated with a location in the target product on the display device 120 based on the defect characteristic value of the target product, output from the first pre-trained model 103.

In another embodiment, the prediction unit 106 may predict a defect of the target product by inputting not only a feature indicating a feature quantity of the three-dimensional shape of the target product but also conditional information indicating one or more manufacturing conditions of the target product to the first pre-trained model 103.

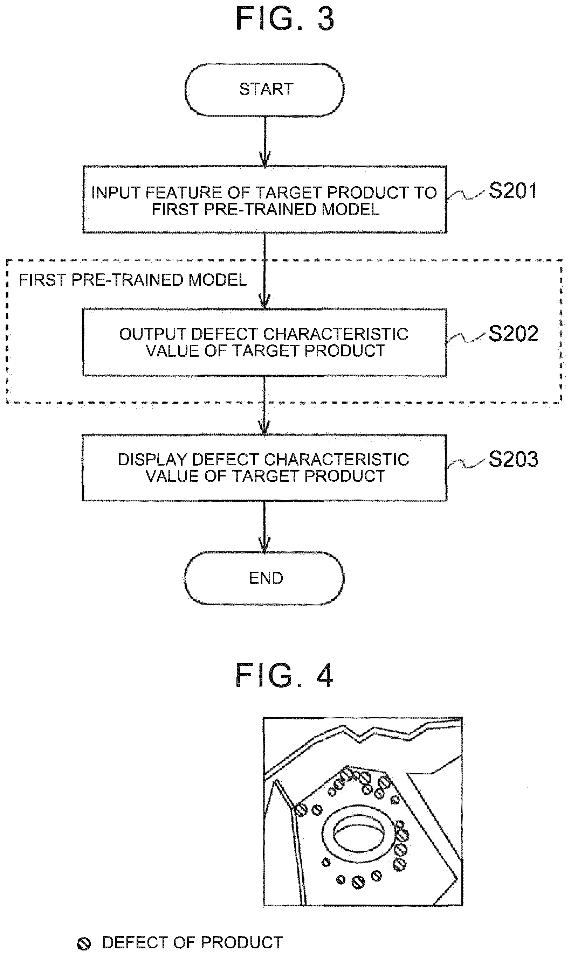

FIG. 4 is a view showing an example of an image showing a prediction result of defects of the target product. In the example shown in FIG. 4, the defects of the target product are shown location by location. In the example shown in FIG. 4, the defects are represented by circle marks for the sake of convenience. Alternatively, the defects of the target product may be represented location by location by using color indication or various shapes. In this case, the degree of defect of the target product may be expressed by the type of color. The degree of defect of the target product may also be expressed by the size of the shape indicating each defect.

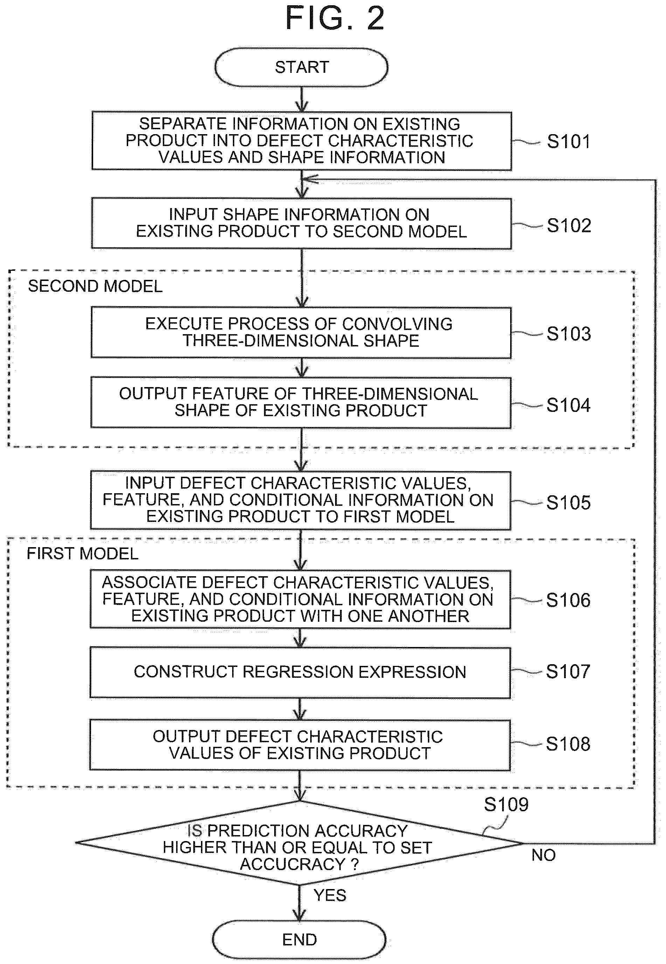

FIG. 2 is a flowchart showing an example of a process of training the first model 103 and the second model 104. In step S101, the separation unit 101 of the prediction apparatus 10 separates the information on the existing product into the defect characteristic values and the shape information. In step S102, the model control unit 102 inputs the shape information on the existing product to the second model 104.

In step S103, the second model 104 executes a process of convolving the three-dimensional shape of the existing product by using the shape information on the existing product, and generates a feature of the three-dimensional shape of the existing product. In step S104, the second model 104 outputs the generated feature of the three-dimensional shape of the existing product.

In step S105, the model control unit 102 inputs the defect characteristic values of the existing product, obtained in step S101, the feature of the existing product, output in step S104, and the conditional information on the existing product to the first model 103.

In step S106, the first model 103 associates the defect characteristic values, feature, and conditional information on the existing product with one another. In step S107, the first model 103 constructs a regression expression based on the association among the defect characteristic values, feature, and conditional information on the existing product. In step S108, the first model 103 outputs the defect characteristic values respectively associated with locations in the existing product.

In step S109, the prediction accuracy determining unit 105 compares the defect characteristic values output from the first model 103 with the defect characteristic values of the existing product, obtained by simulation, and determines whether the defect prediction accuracy of the first model 103 is higher than or equal to a set accuracy. When the defect prediction accuracy of the first model 103 is lower than the set accuracy (NO), the process returns to step S102, and the first model 103 and the second model 104 are repeatedly trained. On the other hand, when the defect prediction accuracy of the first model 103 is higher than or equal to the set accuracy (YES), the process of FIG. 2 ends.

FIG. 3 is a flowchart showing an example of a process of predicting a defect of a target product. In step S201, the prediction unit 106 of the prediction apparatus 10 inputs a feature indicating the feature quantity of the three-dimensional shape of the target product to the first pre-trained model 103 trained through the process shown in FIG. 2. In step S202, the first pre-trained model 103 outputs a defect characteristic value indicating a defect associated with a location in the target product. In step S203, the prediction unit 106 displays the defect characteristic value of the target product, output by the first pre-trained model 103, on the display device 120, and the process of FIG. 3 ends.

In the above embodiment, the first model 103 is trained based on the defect characteristic value indicating the defect associated with the location in the existing product, the feature of the three-dimensional shape of the existing product, and the conditional information indicating the manufacturing condition of the existing product. When a feature of the three-dimensional shape of the target product and conditional information indicating a manufacturing condition of the target product are input to the first pre-trained model 103, the first pre-trained model 103 outputs a defect characteristic value indicating a defect associated with a location in the target product.

The defect characteristic value of the existing product correlates with the defect characteristic value of the target product. The three-dimensional shape of a product correlates with a defect of the product. The manufacturing condition of a product correlates with a defect of the product. Therefore, a defect associated with the three-dimensional shape of the target product is able to be predicted by using the first pre-trained model 103 trained based on the defect characteristic value, the feature of the three-dimensional shape, and the conditional information indicating the manufacturing condition, of the existing product. Therefore, a defect due to the shape of the target product, such as a new product, is able to be predicted location by location.

When the product is a casting, the defect of the product, indicated by the defect characteristic value, includes at least one of seizure, shrinkage, flow line, galling, raw material deformation, die cracking, and entrapment of the product. Thus, it is possible to predict seizure, shrinkage, flow line, galling, raw material deformation, die cracking, and entrapment of the target product. Particularly, it is possible to predict seizure, shrinkage, flow line, galling, raw material deformation, die cracking, and entrapment of the target product location by location.

The defect characteristic value includes a value indicating the degree of defect of the target product. Therefore, it is possible to predict the degree of defect of the target product location by location.

When the product is a casting, the first pre-trained model 103 may be further trained by at least one of a die volume of the casting, a casting volume, a casting surface area, and a thickness of the casting. Thus, the first pre-trained model 103 is capable of predicting a defect with considerations to the die volume of a casting, a casting volume, a casting surface area, and the thickness of the casting.

When the product is a casting, the manufacturing condition includes at least one of molten metal type, molten metal temperature, internal cooling temperature, water flow time, die temperature, die surface treatment, cycle time, die time, die opening sequence, spray application amount, spray time, and air blow sequence. Thus, it is possible to predict a defect of the target product location by location based on these various manufacturing conditions.

In the above example, a program includes a command set (or software code) for causing a computer to execute one or more functions described in the embodiment when the program is loaded onto the computer. The program may be stored in a non-transitory computer-readable medium or a tangible non-transitory storage medium. Nonrestrictive examples of the computer-readable medium or tangible non-transitory storage medium include memory technologies, such as a random-access memory (RAM), a read-only memory (ROM), a flash memory, a solid-state drive (SSD), and others, optical disk storages, such as a CD-ROM, a digital versatile disc (DVD), a Blu-ray (registered trademark) disc, and others, and magnetic storage devices, such as a magnetic cassette, a magnetic tape, a magnetic disk storage, and others. The program may be transmitted on a temporary computer-readable medium or communication medium. Nonrestrictive examples of the temporary computer-readable medium or communication medium include an electrical, optical, acoustic, or other-type propagation signals.

The invention is not limited to the above-described embodiment and may be modified as needed without departing from the scope of the invention. For example, in the above embodiment, the prediction apparatus 10 that is a single apparatus may be regarded as a prediction system. Alternatively, in another embodiment, a prediction system may be implemented by a plurality of apparatuses. For example, the separation unit 101, model control unit 102, first model 103, second model 104, prediction accuracy determining unit 105, and prediction unit 106 implemented in the arithmetic unit 100 may be implemented in a distributed manner among a plurality of apparatuses.

## Claims

1. A prediction system (10) configured to predict a defect of a target product, the prediction system (10) comprising a first pre-trained model (103) trained based on a defect characteristic value indicating a defect associated with a location in an existing product, a feature of a three-dimensional shape of the existing product, and conditional information indicating a manufacturing condition of the existing product, wherein
the first pre-trained model (103) is configured to, when a feature of a three-dimensional shape of the target product is input, output a defect characteristic value indicating a defect associated with a location in the target product,
the prediction system (10) further comprises a second pre-trained model (104) configured to, when shape information indicating the three-dimensional shape of the existing product is input, output the feature of the three-dimensional shape of the existing product, and
the first pre-trained model (103) is trained by using the feature output from the second pre-trained model (104).

2. The prediction system (10) according to claim 1, wherein:
the product is a casting; and
the defect of the product, indicated by the defect characteristic value, includes at least one of seizure, shrinkage, flow line, galling, raw material deformation, die cracking, and entrapment of the product.

3. The prediction system (10) according to claim 1 or 2, wherein the defect characteristic value includes a value indicating a degree of the defect of the product.

4. The prediction system (10) according to any one of claims 1 to 3, wherein, when the product is a casting, the first pre-trained model (103) is further trained by at least one of a die volume of the casting, a casting volume, a casting surface area, and a thickness of the casting.

5. The prediction system (10) according to any one of claims 1 to 4, wherein, when the product is a casting, the manufacturing condition includes at least one of molten metal type, molten metal temperature, internal cooling temperature, water flow time, die temperature, die surface treatment, cycle time, die time, die opening sequence, spray application amount, spray time, and air blow sequence.

6. The prediction system (10) according to any one of claims 1 to 5, further comprising a display device (120), wherein
the defect characteristic value indicating the defect associated with the location in the target product is displayed on the display device (120).

7. A prediction method of predicting a defect of a target product, the prediction method comprising
inputting, by a computer, a feature of a three-dimensional shape of the target product to a first pre-trained model (103), trained based on a defect characteristic value indicating a defect associated with a location in an existing product, shape information indicating a three-dimensional shape of the existing product, and conditional information indicating a manufacturing condition of the existing product,
causing the first pre-trained model (103) to output a defect characteristic value indicating a defect associated with a location in the target product,
inputting, by the computer, the shape information indicating the three-dimensional shape of the existing product to a second pre-trained model (104) and causing the second pre-trained model (104) to output a feature of the three-dimensional shape of the existing product, and
training, by the computer, the first pre-trained model (103) by using the feature output from the second pre-trained model (104).

8. The prediction method according to claim 7, wherein, when the product is a casting, the defect of the product, indicated by the defect characteristic value, includes at least one of seizure, shrinkage, flow line, galling, raw material deformation, die cracking, and entrapment of the product.

9. The prediction method according to claim 7 or 8, wherein the defect characteristic value includes a value indicating a degree of the defect of the product.

10. The prediction method according to any one of claims 7 to 9, wherein, when the product is a casting, the first pre-trained model (103) is further trained by at least one of a die volume of the casting, a casting volume, a casting surface area, and a thickness of the casting.

11. The prediction method according to any one of claims 7 to 10, wherein, when the product is a casting, the manufacturing condition includes at least one of molten metal type, molten metal temperature, internal cooling temperature, water flow time, die temperature, die surface treatment, cycle time, die time, die opening sequence, spray application amount, spray time, and air blow sequence.

12. The prediction method according to any one of claims 7 to 11, further comprising displaying the defect characteristic value indicating the defect associated with the location in the target product on a display device (120).

13. A non-transitory storage medium storing a program that is a first pre-trained model (103) configured to predict a defect of a target product, and a program that is a second pre-trained model (104), wherein:
the first pre-trained model (103) is trained based on a defect characteristic value indicating a defect associated with a location in an existing product, a feature of a three-dimensional shape of the existing product, and conditional information indicating a manufacturing condition of the existing product;
the first pre-trained model (103) is configured to, when a feature of a three-dimensional shape of the target product is input, output a defect characteristic value indicating a defect associated with a location in the target product;
the second pre-trained model (104) is configured to, when shape information indicating the three-dimensional shape of the existing product is input, output the feature of the three-dimensional shape of the existing product; and
the first pre-trained model (103) is trained by using the feature output from the second pre-trained model (104).

## Patentansprüche

1. Vorhersagesystem (10), welches so konfiguriert ist, dass es einen Defekt eines Zielprodukts vorhersagt, wobei das Vorhersagesystem (10) ein erstes zuvor trainiertes Modell (103) aufweist, das auf Basis eines Defekt-Kennwerts, der einen Defekt anzeigt, der einem Ort in einem existierenden Produkt zugeordnet ist, einer Eigenschaft einer dreidimensionalen Gestalt des existierenden Produkts, sowie von Zustandsinformationen, die einen Herstellungszustand des existierenden Produkts anzeigen, trainiert wird, wobei
das erste zuvor trainierte Modell (103) so konfiguriert ist, dass es, wenn eine Eigenschaft einer dreidimensionalen Gestalt des Zielprodukts eingegeben wird, einen Defekt-Kennwert ausgibt, der einen Defekt anzeigt, der einem Ort in dem Zielprodukt zugeordnet ist,
das Vorhersagesystem (10) ferner ein zweites zuvor trainiertes Modell (104) aufweist, das so konfiguriert ist, dass es, wenn Gestaltinformationen eingegeben werden, welche die dreidimensionale Gestalt des existierenden Produkts anzeigen, die Eigenschaft der dreidimensionalen Gestalt des existierenden Produkts ausgibt, und
das erste zuvor trainierte Modell (103) durch Verwenden der von dem zweiten zuvor trainierten Modell (104) ausgegebenen Eigenschaft trainiert wird.

2. Vorhersagesystem (10) nach Anspruch 1, wobei:
das Produkt ein Gussstück ist; und
der durch den Defekt-Kennwert angezeigte Defekt des Produkts zumindest eines aus Festfressen, Schrumpfung, Strömungslinie, Abrieb, Rohmaterialverformung, Gussform-Spaltbildung und Klemmen des Produkts beinhaltet.

3. Vorhersagesystem (10) nach Anspruch 1 oder 2, wobei der Defekt-Kennwert einen Wert beinhaltet, der ein Ausmaß des Defekts des Produkts anzeigt.

4. Vorhersagesystem (10) nach einem der Ansprüche 1 bis 3, wobei, wenn das Produkt ein Gussstück ist, das erste zuvor trainierte Modell (103) ferner durch zumindest eines aus einem Gussformvolumen des Gussstücks, einem Gussstückvolumen, einer Gussstückoberflächenausdehnung und einer Dicke des Gussstücks trainiert ist.

5. Vorhersagesystem (10) nach einem der Ansprüche 1 bis 4, wobei, wenn das Produkt ein Gussstück ist, der Herstellungszustand zumindest eines aus einem Typ von geschmolzenem Metall, einer Temperatur des geschmolzenen Metalls, einer inneren Kühltemperatur, einer Wasserströmungszeit, einer Gussformtemperatur, einer Gussformoberflächenbehandlung, einer Zykluszeit, einer Gussformzeit, einer Gussform-Öffnungssequenz, einer Sprühaufbringungsmenge, einer Sprühzeit und einer Luftblassequenz beinhaltet.

6. Vorhersagesystem (10) nach einem der Ansprüche 1 bis 5, ferner aufweisend eine Anzeigevorrichtung (120), wobei
der Defekt-Kennwert, der den Defekt anzeigt, der dem Ort in dem Zielprodukt zugeordnet ist, auf der Anzeigevorrichtung (120) angezeigt wird.

7. Vorhersageverfahren zum Vorhersagen eines Defekts eines Zielprodukts, wobei das Vorhersageverfahren aufweist:
Eingeben, durch einen Computer, einer Eigenschaft einer dreidimensionalen Gestalt des Zielprodukts in ein erstes zuvor trainiertes Modell (103), das auf Basis eines Defekt-Kennwerts, der einen Defekt anzeigt, der einem Ort in einem existierenden Produkt zugeordnet ist, von Gestaltinformationen, die eine dreidimensionale Gestalt des existierenden Produkts anzeigen, sowie von Zustandsinformationen, die einen Herstellungszustand des existierenden Produkts anzeigen, trainiert wird,
Veranlassen, dass das erste zuvor trainierte Modell (103) einen Defekt-Kennwert ausgibt, der einen Defekt anzeigt, der einem Ort in dem Zielprodukt zugeordnet ist,
Eingeben, durch den Computer, der Gestaltinformationen, welche die dreidimensionale Gestalt des existierenden Produkts anzeigen, in ein zweites zuvor trainiertes Modell (104) und Veranlassen, dass das zweite zuvor trainierte Modell (104) eine Eigenschaft der dreidimensionalen Gestalt des existierenden Produkts ausgibt, und
Trainieren, durch den Computer, des ersten zuvor trainierten Modells (103) durch Verwendung der von dem zweiten zuvor trainierten Modell (104) ausgegebenen Eigenschaft.

8. Vorhersageverfahren nach Anspruch 7, wobei, wenn das Produkt ein Gussstück ist, der durch den Defekt-Kennwert angezeigte Defekt des Produkts zumindest eines aus Festfressen, Schrumpfung, Strömungslinie, Abrieb, Rohmaterialverformung, Gussform-Spaltbildung und Klemmen des Produkts beinhaltet.

9. Vorhersageverfahren nach Anspruch 7 oder 8, wobei der Defekt-Kennwert einen Wert beinhaltet, der ein Ausmaß des Defekts des Produkts anzeigt.

10. Vorhersageverfahren nach einem der Ansprüche 7 bis 9, wobei, wenn das Produkt ein Gussstück ist, das erste zuvor trainierte Modell (103) ferner durch zumindest eines aus einem Gussformvolumen des Gussstücks, einem Gussstückvolumen, einer Gussstückoberflächenausdehnung und einer Dicke des Gussstücks trainiert wird.

11. Vorhersageverfahren nach einem der Ansprüche 7 bis 10, wobei, wenn das Produkt ein Gussstück ist, der Herstellungszustand zumindest eines aus einem Typ von geschmolzenem Metall, einer Temperatur des geschmolzenen Metalls, einer inneren Kühltemperatur, einer Wasserströmungszeit, einer Gussformtemperatur, einer Gussformoberflächenbehandlung, einer Zykluszeit, einer Gussformzeit, einer Gussform-Öffnungssequenz, einer Sprühaufbringungsmenge, einer Sprühzeit und einer Luftblassequenz beinhaltet.

12. Vorhersageverfahren nach einem der Ansprüche 7 bis 11, ferner aufweisend ein Anzeigen des Defekt-Kennwerts, der den dem Ort in dem Zielprodukt zugeordneten Defekt anzeigt, auf einer Anzeigevorrichtung (120).

13. Nichtflüchtiges Speichermedium, das ein Programm, bei dem es sich um ein erstes zuvor trainiertes Modell (103) handelt, das so konfiguriert ist, dass es einen Defekt eines Zielprodukts vorhersagt, und ein Programm, bei dem es sich um ein zweites zuvor trainiertes Modell (104) handelt, speichert, wobei:
das erste zuvor trainierte Modell (103) auf Basis eines Defekt-Kennwerts, welcher einen Defekt anzeigt, der einem Ort in einem existierenden Produkt zugeordnet ist, einer Eigenschaft einer dreidimensionalen Gestalt des existierenden Produkts, sowie Zustandsinformationen, die den Herstellungszustand des existierenden Produkts anzeigen, trainiert wird;
das erste zuvor trainierte Modell (103) so konfiguriert ist, dass es, wenn eine Eigenschaft einer dreidimensionalen Gestalt des Zielprodukts eingegeben wird, einen Defekt-Kennwert ausgibt, der einen Defekt anzeigt, der einem Ort in dem Zielprodukt zugeordnet ist;
das zweite zuvor trainierte Modell (104) so konfiguriert ist, dass es, wenn Gestaltinformationen, welche die dreidimensionale Gestalt des existierenden Produkts anzeigen, eingegeben werden, die Eigenschaft der dreidimensionalen Gestalt des existierenden Produkts ausgibt; und
das erste zuvor trainierte Modell (103) unter Verwendung der von dem zweiten zuvor trainierten Modell (104) ausgegebenen Eigenschaft trainiert wird.

## Revendications

1. Système de prédiction (10) configuré pour prédire un défaut d'un produit cible, le système de prédiction (10) comprenant un premier modèle pré-entraîné (103) formé sur la base d'une valeur caractéristique de défaut indiquant un défaut associé à un emplacement dans un produit existant, une caractéristique d'une forme tridimensionnelle du produit existant, et des informations conditionnelles indiquant une condition de fabrication du produit existant, dans lequel
le premier modèle pré-entraîné (103) est configuré pour, lorsqu'une caractéristique d'une forme tridimensionnelle du produit cible est saisie, produire une valeur caractéristique de défaut indiquant un défaut associé à un emplacement dans le produit cible,
le système de prédiction (10) comprend en outre un second modèle pré-entraîné (104) configuré pour, lorsque des informations de forme indiquant la forme tridimensionnelle du produit existant sont entrées, produire la caractéristique de la forme tridimensionnelle du produit existant, et
le premier modèle pré-entraîné (103) est entraîné en utilisant la caractéristique émise par le second modèle pré-entraîné (104).

2. Le système de prédiction (10) selon la revendication 1, dans lequel :
le produit est un moulage ; et
le défaut du produit, indiqué par la valeur caractéristique du défaut, comprend au moins l'un des éléments suivants : arrêt, rétrécissement, ligne d'écoulement, frottage, déformation de la matière première, fissuration de la matrice et piégeage du produit.

3. Le système de prédiction (10) selon la revendication 1 ou 2, dans lequel la valeur caractéristique du défaut comprend une valeur indiquant un degré du défaut du produit.

4. Le système de prédiction (10) selon l'une des revendications 1 à 3, dans lequel, lorsque le produit est un moulage, le premier modèle pré-entraîné (103) est en outre entraîné par au moins l'un des éléments suivants : un volume de matrice du moulage, un volume de moulage, une surface de moulage et une épaisseur du moulage.

5. Le système de prédiction (10) selon l'une des revendications 1 à 4, dans lequel, lorsque le produit est un moulage, les conditions de fabrication comprennent au moins l'un des éléments suivants : type de métal fondu, température du métal fondu, température de refroidissement interne, temps d'écoulement de l'eau, température de la matrice, traitement de la surface de la matrice, temps de cycle, temps de la matrice, séquence d'ouverture de la matrice, quantité d'application de la pulvérisation, temps de la pulvérisation et séquence de soufflage de l'air.

6. Le système de prédiction (10) selon l'une des revendications 1 à 5 comprend en outre un dispositif d'affichage (120), dans lequel
la valeur caractéristique du défaut indiquant le défaut associé à l'emplacement dans le produit cible est affichée sur le dispositif d'affichage (120).

7. Méthode de prédiction d'un défaut d'un produit cible, la méthode de prédiction comprenant
l'entrée, par un ordinateur, d'une caractéristique d'une forme tridimensionnelle du produit cible dans un premier modèle pré-entraîné (103), entraîné sur la base d'une valeur caractéristique de défaut indiquant un défaut associé à un emplacement dans un produit existant, d'informations de forme indiquant une forme tridimensionnelle du produit existant, et d'informations conditionnelles indiquant une condition de fabrication du produit existant,
amener le premier modèle pré-entraîné (103) à produire une valeur caractéristique de défaut indiquant un défaut associé à un emplacement dans le produit cible,
l'entrée, par l'ordinateur, des informations de forme indiquant la forme tridimensionnelle du produit existant dans un second modèle pré-entraîné (104) et l'émission par le second modèle pré-entraîné (104) d'une caractéristique de la forme tridimensionnelle du produit existant, et
l'ordinateur entraîne le premier modèle pré-entraîné (103) en utilisant la caractéristique émise par le second modèle pré-entraîné (104).

8. La méthode de prédiction selon la revendication 7, dans laquelle, lorsque le produit est un moulage, le défaut du produit, indiqué par la valeur caractéristique du défaut, comprend au moins l'un des éléments suivants : arrêt, rétrécissement, ligne d'écoulement, frottage, déformation de la matière première, fissuration de la matrice et piégeage du produit.

9. La méthode de prédiction selon la revendication 7 ou 8, dans laquelle la valeur caractéristique du défaut comprend une valeur indiquant un degré du défaut du produit.

10. La méthode de prédiction selon l'une des revendications 7 à 9, dans laquelle, lorsque le produit est un moulage, le premier modèle pré-entraîné (103) est en outre entraîné par au moins l'un des éléments suivants : volume de la matrice du moulage, volume du moulage, surface du moulage et épaisseur du moulage.

11. La méthode de prédiction selon l'une des revendications 7 à 10, dans laquelle, lorsque le produit est un moulage, les conditions de fabrication comprennent au moins l'un des éléments suivants : type de métal fondu, température du métal fondu, température de refroidissement interne, temps d'écoulement de l'eau, température de la matrice, traitement de la surface de la matrice, durée du cycle, temps de la matrice, séquence d'ouverture de la matrice, quantité d'application de la pulvérisation, temps de la pulvérisation et séquence de soufflage de l'air.

12. La méthode de prédiction selon l'une des revendications 7 à 11, comprenant en outre l'affichage de la valeur caractéristique du défaut indiquant le défaut associé à l'emplacement dans le produit cible sur un dispositif d'affichage (120).

13. Support de stockage non transitoire stockant un programme qui est un premier modèle pré-entraîné (103) configuré pour prédire un défaut d'un produit cible, et un programme qui est un second modèle pré-entraîné (104), dans lequel :
le premier modèle pré-entraîné (103) est entraîné sur la base d'une valeur caractéristique de défaut indiquant un défaut associé à un emplacement dans un produit existant, une caractéristique d'une forme tridimensionnelle du produit existant, et des informations conditionnelles indiquant une condition de fabrication du produit existant ;
le premier modèle pré-entraîné (103) est configuré pour, lorsqu'une caractéristique d'une forme tridimensionnelle du produit cible est saisie, produire une valeur caractéristique de défaut indiquant un défaut associé à un emplacement dans le produit cible ;
le second modèle pré-entraîné (104) est configuré pour, lorsque des informations de forme indiquant la forme tridimensionnelle du produit existant sont entrées, produire la caractéristique de la forme tridimensionnelle du produit existant ; et
le premier modèle pré-entraîné (103) est entraîné à l'aide de la caractéristique émise par le second modèle pré-entraîné (104).
